# EUROPEAN PATENT APPLICATION

(11) **EP 3 415 928 A1**
(43) Date of publication of application: **19.12.2018**
(21) Application number: 17175652.1
(22) Date of filing: 13.06.2017
(51) Int. Cl.: G01R 15/04, G01R 15/06, H01G 4/30

(54) **HIGH-VOLTAGE IMPEDANCE ASSEMBLY**

(71) Applicant: 3M Innovative Properties Company, Saint Paul, MN 55133-3427 (US)
(72) Inventor: Stalder, Michael, 47589 Uedem (DE); van Meijl, Frank, 5712 NK Someren-Eind (NL); Gravermann, Mark, 41812 Erkelenz (DE); Sabo, Andreea, 40549 Düsseldorf (DE); Fangrat, Rainer, 41453 Neuss (DE); Eggert, Sebastian, 40227 Düsseldorf (DE)
(74) Representative: Müller, Bruno

(57) **Abstract**

Impedance assembly (1,2,3,4) for use in a voltage divider (50) for sensing an AC high voltage of between 6 kV and 175 kV of an inner conductor (10) of a power cable (20) distributing electrical energy in a national grid. The assembly has an elongate shape, for accommodation in a longitudinal cavity (280) of an elastic sleeve (260) for insulating the power cable (20). The impedance assembly comprises a substrate (130,131) and at least four dividing capacitors (90,91), electrically connected in series between a high-voltage contact (100) and a low-voltage contact (110,111) such as to provide a combined capacitance of at least 10 picofarad, and operable as a high-voltage side of the voltage divider (50). Each dividing capacitor (90,91) has two electrodes formed by opposed conductive areas (201,202,203,204,205,301,302,303,304,305,306) on or in the substrate (130,131), and a dielectric comprising a portion of the substrate (130,131).

## Description

The present disclosure relates to voltage dividers, and to capacitor assemblies and resistor assemblies for voltage dividers, that can be used for sensing voltages of inner conductors of medium-voltage (MV) or high-voltage (HV) power cables in national grids. It relates in particular to such voltage dividers, capacitor assemblies and resistor assemblies that can be accommodated in shrinkable or expandable or elastic sleeves for insulating such power cables. The disclosure also relates to kits comprising such capacitor assemblies or resistor assemblies and to cable terminations and cable plugs comprising such assemblies.

Medium-voltage power cables transmit power at elevated voltages, typically alternating ("AC") voltages of 6 kV or higher versus ground. Voltages of high-voltage power cables are even higher. In both types of cables peak voltages can occur with voltages of about 75 kV or as high as 175 kV or even 194 kV. Where voltage dividers are used as elements of voltage sensors to sense the voltage of such cables, these dividers must be able to accommodate such peaks without being destroyed.

Voltage dividers for sensing a voltage of an inner conductor of an HV/MV power cable are known, e.g. from the German patent application DE 3702735 A1. Voltage dividers can be formed by a plurality of resistors, capacitors or inductances. Resistors, capacitors and inductances are collectively referred to as impedances in this disclosure.

Voltage sensors can advantageously be accommodated in cable terminations or in separable connectors such as cable plugs. Certain ones of these terminations and plugs comprise expandable or shrinkable tubular sleeves of an insulating material, with a passageway in which the end of the cable can be received. A portion of a voltage sensor, e.g. the voltage divider, can be placed into a cavity of the insulating sleeve, adjacent to the passageway. Such an arrangement offers the advantage that the insulating material of the sleeve can be used to also insulate the voltage divider, and permits wires connecting the voltage divider to the inner connector of the cable to be shorter.

The withstand voltage of a single capacitor or of a single resistor is normally far lower than the 6 kV mentioned above. Therefore, traditionally, a larger number of discrete impedances were connected electrically in series to form a voltage divider between high voltage and ground, so that the voltage drop across each impedance was sufficiently low. The large number of impedances had an impact on the manufacturing cost of such voltage divider chains.

Where the voltage divider of the voltage sensor is accommodated in an insulating sleeve of a termination or of a cable plug, the geometric length of the sleeve poses limitations on the geometric length of the voltage divider. Typical MV cable terminations have a length of 30-50 centimetres (cm), as measured along the cable. The voltage divider should thus not exceed this length, if it is to be accommodated in the termination. One end of the termination is next to the high voltage of the inner conductor, while the opposed end is next to low voltage, mostly ground. The voltage of the inner conductor, i.e. at least 6 kV and up to 175 kV, thus needs to be divided down to zero volt (electrical ground), or to almost zero volt, over this geometric length. In order to reduce the risk of electrical discharges between the high-voltage end of the voltage divider and its low-voltage end, an exposed contact of the first impedance of the voltage divider, which is connected to the high voltage of the inner conductor, is advantageously arranged geometrically as far as possible from an exposed contact of the last impedance of the voltage divider, connected to ground.

Where high precision is required in measuring the voltage of the inner conductor, it should be considered that commercially available capacitors and resistors exhibit some variation of their capacities and resistances with temperature and ambient humidity. Their capacities and resistances also vary with their age. These factors lead to unpredictable changes over time in the electrical properties of the impedances forming a voltage divider chain, which are reflected in unpredictable variations of the divider ratio of the voltage divider in which the impedances are used to divide voltage. Due to these variations, some traditional voltage sensor are less precise in sensing the voltage of the inner conductor.

A voltage divider for an AC voltage sensor on an MV/HV power cable according to the present disclosure should survive peak voltages of up to 175 kV, preferably of up to 200 kV, without being destroyed. It should be able to measure voltages of at least twice the "normal" voltage of the inner conductor versus ground in a normal state of the power network. In medium-voltage power networks, this normal voltage is often considered to be 20.8 kV, and the sensor is thus designed to measure voltages of at least about 42 kV. The voltage divider of the sensor should advantageously provide an electrical output signal that can be processed by standard electronic circuitry, such as an output signal of between 1 Volt and 10 Volt. This target output voltage and the 6 kV to 42 kV voltage range of the inner conductor requires a certain dividing ratio of the voltage divider, namely a dividing ratio in the range of about 1:600 up to about 1:4200 for MV cables and correspondingly higher for HV cables. In order for a sensor to be usable with a variety of different cables, a suitable target dividing ratio may be about 1:10 000. The impedance of the high-voltage side of the voltage divider thus needs to be about 10 000 times as high as the impedance of the low-voltage side of the voltage divider. For a capacitive voltage divider, this requires the capacitance of the high-voltage side to be about 1:10 000 of the capacitance of the low-voltage side.

It is desirable to provide components of AC voltage dividers for accommodation in MV/HV cable terminations or cable plugs that reduce the risk of electrical discharge. The components should also provide for a divider ratio that allows connection to common electronic circuitry. It is further desirable that such components be more cost-efficient. It is also desirable to provide such components that are less susceptible to aging effects and environmental impacts.

The present disclosure attempts to address these needs. According to a first fundamental aspect of this disclosure, it provides an impedance assembly for use in a voltage divider for sensing an AC high voltage of between 6 kV and 175 kV of an inner conductor of a power cable distributing electrical energy in a national grid, wherein the impedance assembly has an elongate shape defining a first end portion and an opposed second end portion, for accommodation in a longitudinal cavity of an elastic sleeve for insulating the power cable, and wherein the impedance assembly comprises
a) a substrate,
b) a high-voltage contact, arranged at the first end portion, for galvanic connection to the inner conductor,
c) a low-voltage contact, arranged at the second end portion at a distance of at least 10 centimetres from the high-voltage contact, for electrical connection to a low voltage of 10 volt or lower, and
d) at least four dividing capacitors, electrically connected in series between the high-voltage contact and the low-voltage contact such as to provide a combined capacitance of at least 10 picofarad, and operable as a high-voltage side of the voltage divider between the low voltage and the high voltage of the inner conductor, wherein each dividing capacitor has two electrodes formed by opposed conductive areas on or in the substrate, and a dielectric comprising a portion of the substrate.

The impedance assembly according to this first fundamental aspect of the present disclosure comprises at least four dividing capacitors. It is therefore also referred to as a "capacitor assembly" herein. It may form a component of a voltage divider. The elongate shape of the impedance assembly facilitates its accommodation in a sleeve of a cable termination or of a cable plug. The arrangement of the high-voltage contact and the low-voltage contact at opposed ends of the impedance assembly, at a distance of at least 10 cm from each other, reduces the risk of discharges between these contacts.

The impedance assembly is suitably shaped to be accommodated in a longitudinal cavity of an elongate elastic sleeve for insulating the power cable. This shape facilitates placement of the impedance assembly in a cable termination, a cable plug or a similar cable accessory which comprises an elastic sleeve. Placement in the sleeve is advantageous in that the existing insulation of the sleeve may be used to also insulate the impedance assembly, whereby the risk of discharges across the impedance assembly is reduced, while no dedicated insulation for the impedance assembly needs to be provided.

The voltage drop across the voltage divider from high voltage to low voltage is effected over at least four dividing capacitors providing a combined capacitance of at least 10 picofarad (pF). This minimum number of dividing capacitors ensures that the voltage drop across each dividing capacitor is moderate and, as a result, that the risk of electrical discharge across each dividing capacitor is low.

The combined capacity of at least 10 pF of the dividing capacitors, at a given dividing ratio of about 1:10'000, allows the low-voltage side capacitor of the voltage divider to have a capacitance of about 100 nanofarad (nF). Such capacitors are available at reasonable cost, with accuracies of 1 % and acceptable capacitance variations with varying temperature and age, e.g. according to NP0.

The construction of the dividing capacitors from conductive areas forming their electrodes and a portion of the substrate forming their dielectric is advantageous over the use of prefabricated discrete capacitors in that it allows tailoring of the accuracy and of the withstand voltage to the required degree. A suitable choice of the material of the substrate of the impedance assembly, for example, may result in an acceptable variation of the capacity with variations in temperature or humidity. Also, suitably choosing an appropriate spacing between conductive areas allows to obtain the desired capacity.

An impedance assembly according to the first fundamental aspect of the present disclosure may be a voltage divider for sensing a voltage of at least 6 kV vs. ground of an inner conductor of a power cable distributing electrical energy in a national grid. Alternatively, an impedance assembly may be a component of such a voltage divider or comprise a component of this voltage divider. In some embodiments, the impedance assembly comprises the high-voltage portion of a voltage divider for sensing a voltage of at least 6 kV vs. ground of an inner conductor of a power cable distributing electrical energy in a national grid.

High voltages of 6 kV vs. ground or higher can be measured using voltage dividers, such as capacitive or resistive voltage dividers. In a voltage divider, at least two impedances ("dividing impedances") are electrically connected in series between the high voltage to be measured and electrical ground. The term "impedance" as used for a physical element refers either to a resistor, a capacitor or to an inductor. The term "impedance" is also used for the electrical property of the physical element, i.e. the resistance of a resistor, the capacitance of a capacitor or the inductance of an inductor. Between the at least two dividing impedances forming the voltage divider, a voltage ("sensing voltage") can be picked up which is proportional to the high voltage, with the proportionality factor or "divider ratio" being the ratio of the value of the high-voltage impedance (i.e. the impedance connected directly to high-voltage) to the value of the low-voltage impedance (i.e. the impedance connected directly to ground).

Voltage dividers in which all dividing impedances are resistors are generally referred to herein as resistive voltage dividers, while voltage dividers in which all dividing impedances are capacitors are referred to herein as capacitive voltage dividers. Alternatively, a voltage divider can be mixed, that is, one dividing impedance is of one type (resistor, capacitor, or inductor), the other dividing impedance is of a different type, such as resistor-capacitor, inductor-resistor, etc.

A dividing impedance is not necessarily a single resistor, capacitor or inductor, but can be made up of two or more impedances. A voltage divider may, therefore, either comprise a single dividing impedance or a chain of dividing impedances, electrically connected in series. Between two of the dividing impedances of a chain, at a midpoint or pick-up point, the sensing voltage can be picked up. All impedances of the divider which are electrically connected between the pick-up point and high voltage form the "high-voltage side" of the divider, and all impedances of the divider which are electrically connected between the pick-up point and ground form the "low-voltage side" of the voltage divider.

Power cables, with which the present impedance assembly can be used, are cables transmitting electrical power over large geographic distances in a national grid. Medium-voltage (MV) and high-voltage (HV) power cables are operated at voltages of 6 kV vs. ground or higher and are designed for currents of tens or hundreds of amperes.

Such power cables mostly comprise a central inner conductor having a diameter of 8 millimetres or more, which transmits the electrical power and carries the current. It is surrounded coaxially by a layer of insulating material forming the main insulation of the cable, which in turn carries on its outer surface a semiconductive layer. Other layers may be present, including, for example, a shielding mesh. An insulating cable sheath forms the outermost layer of the cable.

Impedance assemblies according to the present disclosure are designed to be accommodated in a longitudinal cavity of an elastic sleeve for insulating the power cable. Such sleeves are often comprised in cable terminations, cable plugs or cable splices, but can also be used alone. They have a passageway, in which a longitudinal section of the cable, of a stripped cable or of the inner conductor alone can be received. These sleeves are elastic, as they are designed to be elastically expandable to receive the cable, or elastically shrinkable around the cable. Typical elastically expandable sleeves can be pushed coaxially over the main insulation at an end of the cable, thereby expanding, and by their elastic contraction creating friction to maintain their position on the cable. Elastically shrinkable sleeves can be applied over a section of the cable while held in an expanded state, whereafter they are shrunk down over the cable, for example by applying heat, by removing a support, or in other manners.

Besides the passageway, some sleeves have a longitudinal cavity in their insulation material, extending parallel to the passageway. In this cavity a component of a voltage divider, such as an impedance assembly according to the present disclosure, can be accommodated. Since this cavity is formed in the sleeve, it is close to the inner conductor of the cable, so that any connecting wires can be shorter. Also, this arrangement makes use of the existing insulation in the sleeve. The cavity can be insulated by the insulation material that is arranged around the passageway. Sleeves that are to accommodate, besides the cable, components of a voltage divider can be sized appropriately to insulate both the cable and the components of the voltage divider properly. Normally, no or little additional insulation material is required, compared to sleeves for insulation of the cable only.

Such elastic sleeves may have the shape of an elongate tube, extending longitudinally in the direction of the passageway. The cavity may be elongate and extend longitudinally in the direction of the passageway. The cavity and the passageway may be separated by insulation material. The cavity may have a length of between 20 cm and 50 cm. Correspondingly, the impedance assembly may have a length of between 20 cm and 50 cm. However, the length of the cavity is generally independent of the length of the passageway or the length of the sleeve. The cavity may be shorter than the passageway or the sleeve.

Elastic sleeves as described above may be comprised in cable splices, separable connectors such as cable plugs or in cable terminations. Such elastic sleeves may be equipped with sheds to provide a longer creep current path along the outer surface of the sleeves. They may be equipped with stress control portions for shaping the electrical field.

Generally, the substrate of the impedance assembly is electrically non-conductive. At least a portion of the substrate is operable as a dielectric of a dividing capacitor. In certain embodiments, the substrate is a multilayer PCB comprising two conductive areas in the PCB. The two conductive areas may form electrodes of one of the at least four dividing capacitors. Conductive areas in the PCB are conductive areas inside the PCB, or embedded in the PCB. These areas are thus protected against environmental impacts.

In certain embodiments, the substrate is a multilayer PCB comprising two conductive areas in the PCB and two further conductive areas on outer surfaces of the PCB. The substrate may thus comprise four conductive areas, of which two are in the substrate, and of which two are on the substrate.

Generally, additional layers in the PCB may carry additional conductive areas and thus help obtain larger capacitances of the dividing capacitors. However, additional inner layers may make the PCB more costly.

The impedance assembly has an elongate shape, for example a flat rectangular shape. The rectangular shape defines a length and a width. The impedance assembly may have a rectangular shape having a length of between 10 cm and 50 cm, in particular a length of between 15 cm and 35 cm. It may have a rectangular shape having a width of between 1 cm and 5 cm, in particular a width of between 2 cm and 3 cm.

The elongate shape defines a first end portion and an opposed second end portion. The end portions may be spaced from each other in a length direction of the impedance assembly.

The elongate shape of the impedance assembly may be defined by the shape of the substrate.

The impedance assembly comprises a high-voltage contact, arranged at the first end portion of the impedance assembly. The high-voltage contact is suitable for galvanic connection to the inner conductor. It may be adapted to be galvanically connected to the inner conductor, e.g. by being externally accessible on an outer surface of the impedance assembly. The high-voltage contact may comprise, for example, a soldering point to which a wire can be secured that is connected to the inner conductor. Alternatively, the high-voltage contact may be comprised, for example, in a connector, with which a matching connector can be mated to establish a galvanic connection with the inner conductor. In specific embodiments, the high-voltage contact is an exposed soldering point on an outer surface of a printed circuit board forming the substrate.

The impedance assembly also comprises a low-voltage contact, arranged at the second end portion of the impedance assembly. The low-voltage contact is suitable for connection to ground or to a low voltage of 10 V or less. It may be adapted to be electrically, e.g. galvanically, connected to electrical ground, e.g. by being externally accessible on an outer surface of the impedance assembly. The low-voltage contact may comprise, for example, a soldering point to which a wire can be secured for connection to a grounding element. Alternatively, the low-voltage contact may be comprised, for example, in a connector, with which a matching connector can be mated to establish an electrical connection to a grounding element. In specific embodiments, the low-voltage contact is an exposed soldering point on an outer surface of a printed circuit board forming the substrate.

In certain embodiments, the low-voltage contact may be the ground contact of the voltage divider for sensing the voltage of the inner conductor. In these embodiments, all electrical elements of the voltage divider, including its high-voltage side and its low-voltage side, may be accommodated on the substrate. The low-voltage side may comprise capacitors forming a total capacitance of between 20 nF and 500 nF, particularly of between 40 nF and 100 nF.

In other, alternative embodiments, the low-voltage contact may be the midpoint contact or pick-up contact of the voltage divider. In these embodiments, electrical elements (e.g. impedances) of the voltage divider forming its high-voltage side may be accommodated on the substrate. Electrical elements, such as impedances, forming the low-voltage side of the voltage divider may be accommodated on the substrate or off, i.e. remote from, the substrate.

While the high-voltage contact is arranged at the first end portion of the impedance assembly, the low-voltage contact is arranged at the opposite, second end portion. It is arranged at a distance of at least 10 centimetres from the high-voltage contact. This distance helps reduce the risk of electrical discharge between the high-voltage contact and the low-voltage contact. In certain embodiments, however, the low-voltage contact is arranged at a distance of at least 15 centimetres, or of at least 20 centimetres, from the high-voltage contact. The distance is to be measured purely geometrically, as the length of a straight line between the closest portions of the high-voltage contact and the low-voltage contact. Conductive traces or exposed wire portions leading towards the high-voltage contact or towards the low-voltage contact are not supposed to be considered portions of the respective contact, as they are not adapted for connection, e.g. mechanical connection, to a wire or to a connector.

A capacitor assembly according to the present disclosure comprises at least four dividing capacitors, electrically connected in series between the high-voltage contact and the low-voltage contact of the impedance assembly. These dividing capacitors may form the high voltage side, or a portion of the high-voltage side, of the voltage divider for sensing the voltage of the inner conductor.

The inventors of the present disclosure have discovered that a smaller number of dividing capacitors can result in too high tension across each dividing capacitor and, as a result, in a higher risk of electrical discharge across one of the dividing capacitors.

A greater number of dividing capacitors, e.g. five, six, seven, eight, nine, ten or even more, will reduce tension across each individual capacitor, but the resulting accumulated capacitance of the dividing capacitors will become smaller and smaller. In order to achieve a combined capacitance of at least 10 pF for a useful dividing ratio of the voltage divider, each individual capacitor would have to have a larger capacitance, but a smaller geometric footprint. The inventors of the present disclosure contemplate a maximum number of twenty dividing capacitors. So in certain embodiments, the impedance assembly may comprise between four and eight dividing capacitors, in certain embodiments, it may comprise between four and twelve dividing capacitors, and in certain other embodiments, it may comprise between four and twenty dividing capacitors. In a specific embodiment, the impedance assembly comprises a total of six dividing capacitors. For common geometries, this number appears to provide a good balance between discharge risk across a dividing capacitor and the achievable combined capacitance of the dividing capacitors.

In all these embodiments, the dividing capacitors are electrically connected in series between the high-voltage contact and the low-voltage contact such as to provide a combined capacitance of at least 10 pF, and may be operable as high-voltage side of the voltage divider between the low voltage and the high voltage of the inner conductor.

Voltage dividers, in which impedance assemblies according to the present disclosure can be used, preferably provide an output voltage, as picked up at the midpoint, that can be processed in standard electronic circuitry, for example an output voltage of between 1 Volt and 10 Volt, thus requiring a dividing ratio of about 1:10 000. For a given dividing ratio, a lower overall capacitance of the high-voltage side of the voltage divider requires a lower overall capacitance of the low-voltage side. Due to the high dividing ratio, it is generally desirable for the high-voltage side to have a larger overall capacitance and a corresponding lower impedance. Larger capacitances for the high-voltage side of a voltage divider render the voltage divider less sensitive to effects of parasitic capacitance and increase the precision of the voltage sensing. They are, however, harder and more costly to build where space is restricted.

The desired dividing ratio may depend, inter alia, on the expected voltage of the inner conductor, and/or on the desired sensor output voltage at the midpoint of the voltage divider. Therefore, in certain embodiments of the present disclosure, the at least four dividing capacitors provide a combined, i.e. overall, capacitance of at least 10 pF. In certain of those embodiments, the at least four dividing capacitors are electrically connected in series between the high-voltage contact and the low-voltage contact such as to provide a combined capacitance of at least 20 pF or of at least 50 pF or of at least 100 pF. In certain embodiments, the at least four dividing capacitors are electrically connected in series between the high-voltage contact and the low-voltage contact such as to provide a combined, i.e. overall, capacitance of between 10 pF and 100 pF or of between 20 pF and 60 pF.

Each of the at least four dividing capacitors has two electrodes and a dielectric. The electrodes of each of the at least four dividing capacitors are formed by opposed conductive areas on or in the substrate. The dividing capacitors are thus no discrete surface-mounted components, also referred to as SMDs in this field. Rather they are made of conductive areas on or in the substrate, which are opposed to each other, so that they form capacitor plates. The opposed layers may be parallel to each other. Where two conductive areas form the electrodes of a dividing capacitor, only a portion of one conductive area may be opposed to the other conductive area.

A conductive area may comprise, for example, a layer of conductive metal such as copper, silver or gold. Such a layer of conductive metal may be arranged, e.g. coated, on an inner or outer surface of the substrate. A conductive area may have a thickness of, for example, between 1 µm and 100 µm.

The conductive areas may be arranged on the substrate or in the substrate. A conductive area may, for example, be arranged on an outer surface of the substrate, such as on an outer surface of a PCB. Such an arrangement facilitates establishment of an electrical contact with the conductive area, e.g. by soldering or surface contact.

A conductive area may be arranged in the substrate. Where the substrate is a multilayer PCB, a conductive area may be formed by a conductive portion of an inner layer of the multilayer PCB. A conductive area arranged in the substrate may comprise a portion which is externally accessible, e.g. accessible at an edge of the substrate.

A conductive area may be co-extensive with the substrate. Alternatively, a conductive area may extend over only a portion of the substrate. For example, where the substrate is a flat, rectangular ceramic body of 2 cm by 25 cm size, a conductive area in or on the substrate may have a size of 50 mm by 20 mm.

Where the electrodes of a dividing capacitor are formed by two opposed conductive areas, both conductive areas may be arranged on the substrate. Alternatively, both conductive areas may be arranged in the substrate. Alternatively, one of the conductive areas may be arranged in the substrate, and the other conductive areas may be arranged on the substrate.

Each of the at least four dividing capacitors comprises a dielectric which comprises a portion of the substrate. The dielectric properties of the substrate thus have a bearing on the capacitance of the at least four dividing capacitors. The substrate may be suitably chosen, for example, to minimize the effect of temperature variations on the capacitance of the dividing capacitors. Ceramic materials are known to have dielectric properties that vary comparatively little with temperature at temperatures where power cables are typically used.

The substrate may be chosen, for example, to minimize the effect of humidity variations on the capacitance of the dividing capacitors. Again, ceramic materials are known to have dielectric properties that vary comparatively little with variations in ambient humidity, and may therefore be suitable substrate materials.

According to a second fundamental aspect of this disclosure, it is provided an impedance assembly for use in a voltage divider for sensing an AC (i.e. alternating) high voltage of between 6 kV and 175 kV of an inner conductor of a power cable distributing electrical energy in a national grid, wherein the impedance assembly has an elongate shape defining a first end portion and an opposed second end portion, for accommodation in a longitudinal cavity of an elastic sleeve for insulating the power cable, and wherein the impedance assembly comprises
a) a substrate,
b) a high-voltage contact, arranged at the first end portion, for galvanic connection to the inner conductor,
c) a low-voltage contact, arranged at the second end portion at a distance of at least 10 centimetres from the high-voltage contact, for electrical connection to a low voltage of 10 volt or lower, and
d) a resistor layer, arranged on an inner or an outer surface of the substrate and extending between the first end portion and the second end portion, electrically connected in series between the high-voltage contact and the low-voltage contact such as to provide a resistance of at least 50 MΩ (Mega Ohm), wherein the resistor layer is operable as a high-voltage side of the voltage divider between the low voltage and the high voltage of the inner conductor.

The impedance assembly according to this second fundamental aspect (also referred to herein as the "resistor assembly") provides a resistor in the form of a resistor layer for the high-voltage side of the voltage divider for sensing the voltage of the inner conductor. The resistor layer forms an impedance in the voltage divider. The voltage divider may be a resistive voltage divider or a mixed voltage divider.

Several components of the resistor assembly, such as the substrate, the high voltage contact or the low voltage contact, are also comprised in the capacitor assembly according to the first fundamental aspect of the disclosure described above. These components fulfil the same functions in both impedance assemblies and will therefore not be explained again.

The resistor assembly may form a component of a voltage divider. The elongate shape of the resistor assembly facilitates its accommodation in a sleeve of a cable termination or of a cable plug. The arrangement of the high-voltage contact and the low-voltage contact at opposed ends of the resistor assembly, at a distance of at least 10 cm from each other, reduces the risk of discharges between these contacts.

The resistor assembly is suitably shaped to be accommodated in a longitudinal cavity of an elongate elastic sleeve for insulating the power cable. This shape facilitates placement of the resistor assembly in a cable termination, cable plug or a similar cable accessory which comprises an elastic sleeve. Placement in the sleeve is advantageous in that the existing insulation of the sleeve may be used to also insulate the resistor assembly, whereby the risk of discharges across the resistor assembly is reduced, while no dedicated insulation for the resistor assembly needs to be provided.

The voltage drop across the voltage divider from high voltage to low voltage is effected over the resistor layer, which provides a resistance of at least 50 MΩ. The resistance of the resistor layer, in combination with its extension between the first end portion and the second end portion of the resistor assembly, ensures that the voltage drop across the resistor layer is moderate and, as a result, that the risk of electrical discharge across the resistor layer is low.

The construction of a resistor via a resistor layer is advantageous over the use of prefabricated discrete resistors in that it allows tailoring of the accuracy of the resistance and of the breakdown withstand voltage to the required degree.

A resistor assembly according to the second fundamental aspect of the present disclosure may be the voltage divider for sensing a voltage of at least 6 kV of an inner conductor of a power cable distributing electrical energy in a national grid. Alternatively, such a resistor assembly may be a component of such a voltage divider or comprise a component of such a voltage divider. In some embodiments, the resistor assembly comprises the high-voltage portion of a voltage divider for sensing a voltage of at least 6 kV vs. ground of an inner conductor of a power cable distributing electrical energy in a national grid.

The substrate of a resistor assembly according to the present disclosure may be a mechanical support for other elements of the resistor assembly. The high-voltage contact may be supported by the substrate. The low-voltage contact may be supported by the substrate. The substrate may be, for example, a printed circuit board ("PCB"), such as a single layer PCB or a multilayer PCB, or comprise a PCB. The substrate may comprise a fibre-reinforced polymeric material such as FR4. The substrate may be a single-layer or multilayer ceramic PCB or comprise a single-layer or multilayer ceramic PCB.

Alternatively, the substrate may be a ceramic body, e.g. a single-layer ceramic body or a multi-layer ceramic body.

The substrate of the resistor assembly is electrically non-conductive. The substrate may be, or comprise, a ceramic hydrocarbon material, such as the Rogers 4000 series PCB material. The substrate may alternatively be, or comprise, a PTFE (polytetrafluoroethylene) material or an epoxy material.

The resistor assembly has an elongate shape, for example a flat rectangular shape. The rectangular shape defines a length and a width. The resistor assembly may have a rectangular shape having a length of between 10 cm and 50 cm, in particular a length of between 15 cm and 35 cm. It may have a rectangular shape having a width of between 1 cm and 5 cm, in particular a width of between 2 cm and 3 cm.

The elongate shape defines a first end portion and an opposed second end portion. The end portions may be spaced from each other in a length direction of the resistor assembly. The elongate shape of the resistor assembly may be defined by the shape of the substrate.

The resistor assembly comprises a high-voltage contact, arranged at the first end portion of the resistor assembly. The high-voltage contact is suitable for galvanic connection to the inner conductor. It may be adapted to be galvanically connected to the inner conductor, e.g. by being externally accessible on an outer surface of the resistor assembly. The high-voltage contact may comprise, for example, a soldering point to which a wire can be secured that is connected to the inner conductor. Alternatively, the high-voltage contact may be comprised, for example, in a connector, with which a matching connector can be mated to establish a galvanic connection with the inner conductor. In specific embodiments, the high-voltage contact is an exposed soldering point on an outer surface of a printed circuit board forming the substrate.

The resistor assembly also comprises a low-voltage contact, arranged at the second end portion of the resistor assembly. The low-voltage contact is suitable for connection to ground or to a low voltage of 10 V or less. It may be adapted to be electrically, e.g. galvanically, connected to electrical ground, e.g. by being externally accessible on an outer surface of the resistor assembly. The low-voltage contact may comprise, for example, a soldering point to which a wire can be secured for connection to a grounding element. Alternatively, the low-voltage contact may be comprised, for example, in a connector, with which a matching connector can be mated to establish an electrical connection to a grounding element. In specific embodiments, the low-voltage contact is an exposed soldering point on an outer surface of a printed circuit board forming the substrate.

In certain embodiments, the low-voltage contact may be the ground contact of the voltage divider for sensing the voltage of the inner conductor. In these embodiments, all electrical elements of the voltage divider, including its high-voltage side and its low-voltage side, may be accommodated on the substrate.

In other, alternative embodiments, the low-voltage contact may be the midpoint contact or pick-up contact of the voltage divider. In these embodiments, electrical elements (e.g. impedances) of the voltage divider forming its high-voltage side may be accommodated on the substrate. Electrical elements, such as impedances, forming the low-voltage side of the voltage divider may be accommodated on the substrate or off, i.e. remote from, the substrate.

While the high-voltage contact is arranged at the first end portion of the resistor assembly, the low-voltage contact is arranged at the opposite, second end portion. It is arranged at a distance of at least 10 centimetres from the high-voltage contact. This distance helps reduce the risk of electrical discharge between the high-voltage contact and the low-voltage contact. In certain embodiments, however, the low-voltage contact is arranged at a distance of at least 15 centimetres, or of at least 20 centimetres, from the high-voltage contact. The distance is to be measured purely geometrically, as the length of a straight line between the closest portions of the high-voltage contact and the low-voltage contact. Conductive traces or exposed wire portions leading towards the high-voltage contact or towards the low-voltage contact are not supposed to be considered portions of the respective contact, as they are not adapted for connection, e.g. mechanical connection, to a wire or to a connector.

The distance between the high-voltage contact and the low-voltage contact of the impedance assembly according to the second fundamental aspect is at least 10 cm. The resistor layer extends between the first end portion and the second end portion of the resistor assembly. In order to facilitate a moderate voltage drop across the resistor layer and thus to reduce the risk of electrical discharges between an element on low voltage and an element on high voltage, the resistor layer should have an elongate shape. In other words, the resistor layer should extend lengthwise. Its length direction may be the direction between the first and the second end portion of the impedance assembly. The greater the length of the resistor layer, the smaller the risk of discharge between its ends. Therefore, in certain embodiments of the present disclosure, the resistor layer extends lengthwise for at least 100 mm. In certain of these embodiments, the resistor layer extends lengthwise for at least 120 mm. In certain embodiments, the resistor layer extends lengthwise for between 100 mm and 200 mm.

An impedance assembly according to the second fundamental aspect of the present disclosure may comprise both the high-voltage side and the low-voltage side of the voltage divider for sensing the voltage of the inner conductor. The low-voltage side of the voltage divider may also comprise a resistor layer. Hence, in certain embodiments, an impedance assembly comprising a (first) resistor layer as described herein further comprises a second resistor layer, electrically connected in series with the first resistor layer. The second resistor layer may be operable as a low-voltage side of the voltage divider for sensing a voltage of the inner conductor. A pickup point or midpoint may be provided electrically between the first and the second resistor layer on the substrate.

In the following, technical features are described that may be present in impedance assemblies according to the first fundamental aspect (i.e. those comprising dividing capacitors or inductors) and in impedance assemblies according to the second fundamental aspect (i.e. those comprising a resistor layer) of the present disclosure.

The substrate is electrically non-conductive. The substrate of an impedance assembly (capacitor assembly, inductor assembly, or resistor assembly) according to the present disclosure may be a mechanical support for other elements of the impedance assembly. The high-voltage contact may be supported by the substrate. The low-voltage contact may be supported by the substrate.

In an aspect of this disclosure, the substrate may have different structures. In certain embodiments, the substrate is, or comprises, a PCB. The PCB may be a single layer PCB or a multilayer PCB. The substrate may comprise a fibre-reinforced polymeric material such as FR4. The substrate may be a single-layer or multilayer ceramic PCB or comprise a single-layer or multilayer ceramic PCB.

The substrate may alternatively be, or comprise, a ceramic hydrocarbon material, such as the Rogers 4000 series PCB material. The substrate may alternatively be, or comprise, a PTFE (polytetrafluoroethylene) material or an epoxy material.

In certain embodiments where the substrate is a PCB or comprises a PCB, the PCB comprises ceramic material. The substrate may, for example, comprise a ceramic multilayer PCB or be a ceramic multilayer PCB.

In certain embodiments, the substrate is a ceramic body. The ceramic body may be a solid body having no internal structure, e.g. no internal layer structure. The ceramic body may support, on its outer surfaces, the conductive areas forming the electrodes of the dividing capacitors, or the resistor layer, as the case may be. Ceramic bodies may be particularly cost-effective to manufacture, and may be rugged to withstand mechanical forces.

Generally, a substrate of any form, comprising ceramic material, may exhibit a particularly low variation of its mechanical and electrical parameters as its temperature varies. Certain ceramic materials exhibit a low coefficient of thermal expansion. Others exhibit a particularly low variation of their permittivity with temperature.

Examples of ceramic materials that can be used in substrates of impedance assemblies are silicon nitride, aluminium oxide such as Al₂O₃, aluminium nitride such as AIN, and low-temperature cofire ceramics.

In order to reduce the risk of electrical discharges between elements of an impedance assembly, the impedance assembly, or portions of it, may be embedded in an electrically non-conductive encapsulating material. The encapsulating material may be a hardened resin, for example. Since the impedance assembly has an elongate shape, a middle portion of the impedance assembly may be embedded in the encapsulating material, while the end portions may be free of encapsulating material. In certain embodiments, at least 50% of the geometric length of the impedance assembly is embedded in encapsulating material. In some embodiments, at least 50%, or at least 70%, of the geometric length of the impedance assembly is embedded in encapsulating material. In another specific embodiment, 100% of the geometric length of the impedance assembly, i.e. the entire impedance assembly, is embedded in encapsulating material.

Impedance assemblies according to the present disclosure are suitable for accommodation in a longitudinal cavity of an elastic sleeve for insulating a power cable. Such sleeves are used, inter alia, for cable terminations, cable plugs and cable splices. The length of such terminations, plugs, splices and sleeves is often less than 50 cm. In certain embodiments of the present disclosure, the impedance assembly has a length of 50 centimetres or less. The length is to be measured geometrically in the length direction of the cable on which the termination, splice, plug or sleeve is arranged when in use.

In one aspect, the present disclosure provides a combination of a) a cable termination comprising an elastic sleeve for electrically insulating a power cable, the sleeve having a longitudinal cavity for accommodating an impedance assembly as described herein, and b) an impedance assembly as described herein, arranged in the cavity of the sleeve. In another aspect, the present disclosure provides a combination of a) a cable plug comprising an elastic sleeve for electrically insulating a power cable, the sleeve having a longitudinal cavity for accommodating an impedance assembly as described herein, and b) an impedance assembly as described herein, arranged in the cavity of the sleeve. In a further aspect, the present disclosure provides a combination of a) a cable splice comprising an elastic sleeve for electrically insulating a power cable, the sleeve having a longitudinal cavity for accommodating an impedance assembly as described herein, and b) an impedance assembly as described herein, arranged in the cavity of the sleeve.

The sleeve may be formed in a molding process, where a hollow mold determining the shape of the sleeve is filled with a liquid molding material which then solidifies and forms the sleeve. In certain embodiments according to the present disclosure, the impedance assembly, embedded in an electrically non-conductive encapsulating material or not, is placed in the mold just before the sleeve is molded. The impedance assembly is thereby molded into the sleeve. The cavity of the sleeve, in this case, takes the exact shape of the impedance assembly. This reduces the occurrence of air pockets, the existence of which otherwise may lead to a higher risk of electrical discharges.

The combination of an elastic sleeve with an impedance assembly as disclosed herein can form a portion of a voltage sensor for sensing a voltage of the inner conductor of a power cable in a national grid. The sleeve with the impedance assembly may be ready to be applied around the cable.

In a further aspect, the present disclosure also provides a kit of parts, comprising a) an elastic sleeve for electrically insulating a power cable, the sleeve having a longitudinal cavity for accommodating an impedance assembly as described herein, and b) an impedance assembly as described herein.

The impedance assembly in such a kit may, in particular, be embedded, entirely or partially, in an electrically non-conductive encapsulating material.

Such kits may be adapted to be assembled to form a portion of a voltage sensor for sensing the high voltage of the inner conductor of a MV/HV power cable. For assembly, the impedance assembly may be pushed into the cavity of the sleeve.

In a yet further aspect, the present disclosure provides a power network for distributing energy in a national grid, comprising a power cable including an inner conductor, and a voltage divider, connected to the inner conductor, for sensing an AC (i.e. alternating) high voltage of the inner conductor, the voltage divider comprising an impedance assembly as described herein.

The invention will now be described in more detail with reference to the following Figures exemplifying particular embodiments of the invention. Some of the Figures may be not to scale, and certain dimensions, e.g. thicknesses, may be drawn exaggerated to enhance clarity.
- Fig. 1: Circuit diagram of a voltage divider connected to a power cable;
- Fig. 2: Longitudinal sectional view of a first impedance assembly according to the present disclosure, where the substrate comprises a PCB;
- Fig. 3: Longitudinal sectional view of a second impedance assembly according to the present disclosure, where the substrate comprises a multilayer PCB;
- Fig. 4: Longitudinal sectional view of the first impedance assembly, embedded in an encapsulating material;
- Fig. 5: Top view of a third impedance assembly according to the present disclosure, comprising a resistor layer; and
- Fig. 6: Perspective view of an impedance assembly according to the present disclosure, accommodated in a cavity of an elastic sleeve.

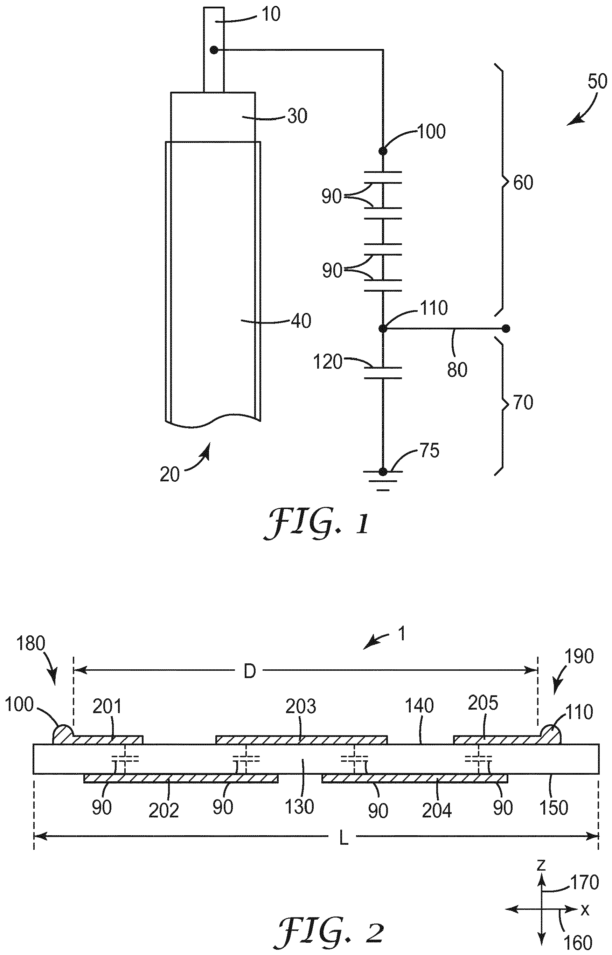

The circuit diagram of **Figure 1** illustrates a voltage divider for sensing a voltage of an inner conductor 10 of a high-voltage power cable 20. An end portion of the cable 20 is shown in plan view. It is stripped down, so that the main insulation layer 30 and a semiconductive layer 40 are visible, which surround the inner conductor 10. When the cable 20 is in use, the inner conductor 10 is typically at a voltage of between 6 kV and 175 kV vs. electrical ground and conducts alternating currents of tens of amperes up to hundreds of amperes.

For sensing the voltage of the inner conductor 10, a voltage divider 50 is galvanically connected to the inner conductor 10 and to electrical ground 75. The voltage divider 50 comprises a high-voltage side 60 and a low-voltage side 70. A divided voltage can be picked up at a midpoint 80 of the voltage divider 50. The divided voltage is proportional to the voltage of the inner conductor 10, with the proportionality factor being the dividing ration of the voltage divider 50.

The high-voltage side 60 of the voltage divider 50 consists of four dividing capacitors 90, electrically connected in series between a high-voltage contact 100 and a low-voltage contact 110 of the voltage divider 50. The low-voltage contact 110 provides access to the divided voltage at the midpoint 80. Each of the four dividing capacitors 90 has a capacitance of 80 pF, so that they provide a combined capacitance of 20 pF.

The low-voltage side 70 of the voltage divider 50 comprises a single capacitor, referred to as the low-voltage capacitor 120. It is connected between the midpoint 80 and electrical ground 75. The low-voltage capacitor 120 has a capacitance of 200 nF and an NP0 rating for temperature stability.

The dividing ratio of the voltage divider 50 is about 1:10 000. If the inner conductor 10 is at 50 kV, the output voltage of the voltage divider 50 at the low-voltage contact 110 is about 5 V. Voltages of that magnitude can be processed by standard electronic circuitry.

The large voltage drop across the four dividing capacitors 90 from 50 kV to 5V on the high-voltage side 60 of the voltage divider 50 requires specific mechanical and electrical designs, as will be explained below.

**Figure 2** is a longitudinal sectional view of a first impedance assembly 1 according to the present disclosure. The first impedance assembly 1 comprises a substrate 130, which is a PCB 130 made of FR4 material. The PCB 130 has two major surfaces, an upper major surface 140 and an opposed lower major surface 150, and it is about 1 mm thick.

The impedance assembly 1 has an elongate shape. It extends in length directions between a first end portion 180 and an opposed second end portion 190. Length (x) directions of the impedance assembly 1 are indicated by arrow 160, and its thickness (z) directions are indicated by arrow 170. Width directions are orthogonal to length directions 160 and thickness directions 170.

The impedance assembly 1 has a high-voltage contact 100 on its first end portion 180 for galvanic connection to an inner conductor 10 of a power cable 20, and a low-voltage contact 110 on its second end portion 190 for connection to a low voltage of 10 Volt or less. Both the high-voltage contact 100 and the low-voltage contact 110 comprise a respective soldering pad to facilitate connection of a wire. Four dividing capacitors 90 are electrically connected in series between the high-voltage contact 100 and the low-voltage contact 110. These dividing capacitors 90 are operable as a high-voltage side 60 of a voltage divider 50 for sensing the voltage of an inner conductor 10 of a power cable 20, as shown in Figure 1.

Physically, the electrodes of each of the four dividing capacitors 90 are formed by opposed conductive areas, coated on the major surfaces 140, 150 of the PCB 130 as 12 µm thin copper layers. Thicker copper layers, such as 35 µm or 70 µm thick copper layers may be used alternatively. A first conductive area 201, arranged on the upper surface 140 of the PCB 130, and an opposed second conductive area 202, arranged on the lower surface 150, form the electrodes of the first (leftmost, in Figure 2) dividing capacitor 90. The second conductive area 202 and a third conductive area 203 form the second dividing capacitor 90, the third conductive area 203 and a fourth conductive area 204 form the third dividing capacitor 90, and the fourth conductive area 204 and a fifth conductive area 205 form the fourth (rightmost, in Figure 2) dividing capacitor 90. Each of the four dividing capacitors 90 has a capacitance of about 48 pF, resulting in a combined capacitance of the four dividing capacitors of about 12 pF.

The dielectric of each of the four dividing capacitors 90 is formed by respective portions of the substrate of the PCB 130, located between those portions of the opposed conductive areas which are arranged directly opposite to each other.

The first conductive area 201 is galvanically connected to the high-voltage contact 100, and the fifth conductive area 205 is galvanically connected to the low-voltage contact 110.

The geometric distance D between the high-voltage contact 100 and the low-voltage contact 110 is about 21 cm. This distance helps ensure that the risk of electrical discharges between any two electrodes 201, 202, 203, 204, 205 remains low, and that the risk of discharge between the high-voltage contact 100 and the low-voltage contact 110 is low.

The geometric length L of the impedance assembly 1 is about 25 cm, so that the impedance assembly 1 can be accommodated in a cavity of even a relatively short elastic sleeve for insulating a power cable.

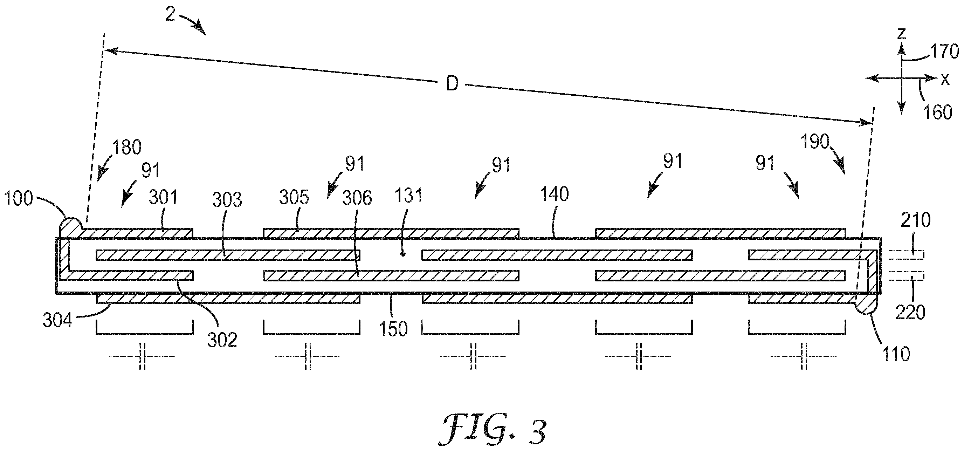

**Figure 3** is a longitudinal sectional view of a second impedance assembly 2 according to the present disclosure. The second impedance assembly 2 comprises a substrate 131, which is a multilayer ceramic PCB 131. The PCB 131 has two major surfaces: an upper major surface 140 and an opposed lower major surface 150, and it is about 2 mm thick.

The impedance assembly 2 has an elongate shape. It extends in length directions between a first end portion 180 and an opposed second end portion 190. Length (x) directions of the impedance assembly 1 are indicated by arrow 160, and its thickness (z) directions are indicated by arrow 170. Width directions are orthogonal to length directions 160 and thickness directions 170.

Like the first impedance assembly 1 of Figure 2, the second impedance assembly 2 has a high-voltage contact 100 on its first end portion 180 for galvanic connection to an inner conductor 10 of a power cable 20, and a low-voltage contact 110 on the lower surface 150 of the second end portion 190 for connection to a low voltage of 10 Volt or less. Both the high-voltage contact 100 and the low-voltage contact 110 comprise a respective soldering pad to facilitate connection of a wire. Their geometric distance D is about 30 cm, with the length of the entire impedance assembly 2 being about 32 cm.

Different from the single-layer PCB 130 of the first impedance assembly 1, the PCB 131 of the second impedance assembly 2 is a multilayer PCB. It comprises two internal layers in the substrate 131 forming conductive areas inside the PCB 131, namely an upper inner layer 210 and a lower inner layer 220.

Five dividing capacitors 91 are electrically connected in series between the high-voltage contact 100 and the low-voltage contact 110. These dividing capacitors 91 are operable as a high-voltage side 60 of a voltage divider 50 for sensing the voltage of an inner conductor 10 of a power cable 20, as shown in Figure 1.

Each of the dividing capacitors 91 is formed by four conductive areas. This will be described for the leftmost dividing capacitor 91. All other dividing capacitors 91 are formed in the same manner.

The leftmost dividing capacitor 91 (in Figure 3) comprises two electrodes. The first electrode comprises a first conductive area 301 on the upper surface 140 of the PCB 131 and a second conductive area 302 in the lower inner layer 220. The first and the second conductive areas 301, 302 are electrically connected with each other. The second electrode comprises a third conductive area 303 in the upper inner layer 210 and a fourth conductive area 304 on the lower outer surface 150 of the PCB 131. The third and the fourth conductive area 303, 304 are not galvanically connected with each other, but are on floating potential. Only that portion of each respective conductive area 301, 302, 303, 304 forms the dividing capacitor 91 which overlaps with the other three conductive areas 301, 302, 303, 304. The size of the overlapping area of the four conductive areas 301, 302, 303, 304 forming the leftmost dividing capacitor 91 is about 30 mm in length direction 160 and 20 mm in width direction. Each of the dividing capacitors 91 has a capacitance of about 100 pF, so that the combined capacitance of the five dividing capacitors 91, connected in series, is about 20 pF.

The portions of the ceramic substrate of the PCB 131 between the first and the third conductive areas 301, 303, between the third and the second conductive areas 303, 302, and between the second and the fourth conductive areas 302, 304 forms the dielectric of the leftmost dividing capacitor 91. It has a relative permittivity εᵣ of about 4.0. Due to the substrate being a ceramic material, its coefficient of thermal expansion is comparatively low, which keeps the distances between opposed conductive areas less variable with temperature variations, resulting in a less variable capacitance of the dividing capacitor 91. Also, electrical properties of a ceramic substrate generally vary less with ambient humidity than those of polymeric substrates, which reduces variations in the relative permittivity of the dielectric of a dividing capacitor 91, and thereby the corresponding variations of the capacitance of the dividing capacitor 91.

The adjacent dividing capacitor 91 (second from left in Figure 3) is formed by a similar arrangement of conductive areas: a fifth conductive area 305 on the top surface 140, the third conductive area 303, a sixth conductive area 306 in the lower inner layer 220 and the fourth conductive area 304. Generally, in this embodiment of the disclosure, adjacent dividing capacitors 91 are electrically connected with each other via certain conductive areas extending from one dividing capacitor 91 into the adjacent dividing capacitor 91, so that a first portion of a conductive area forms an electrode of one dividing capacitor 91, and a second portion of the same conductive area forms an electrode of the adjacent dividing capacitor 91.

The additional conductive areas in the inner layers 210, 220 of the PCB 131 help increase the capacitance of the dividing capacitors 91. However, the distance between two opposed conductive areas in the second impedance assembly 2 is smaller than the corresponding distance between opposed conductive areas in the first impedance assembly 1, which results in a higher risk of electrical discharge between opposed conductive areas. So in order to obtain a suitable dividing ratio and at the same time limiting the risk of discharges, a suitable number of internal conductive areas, such as conductive areas 302, 303, can be identified by calculation and standard experiments.

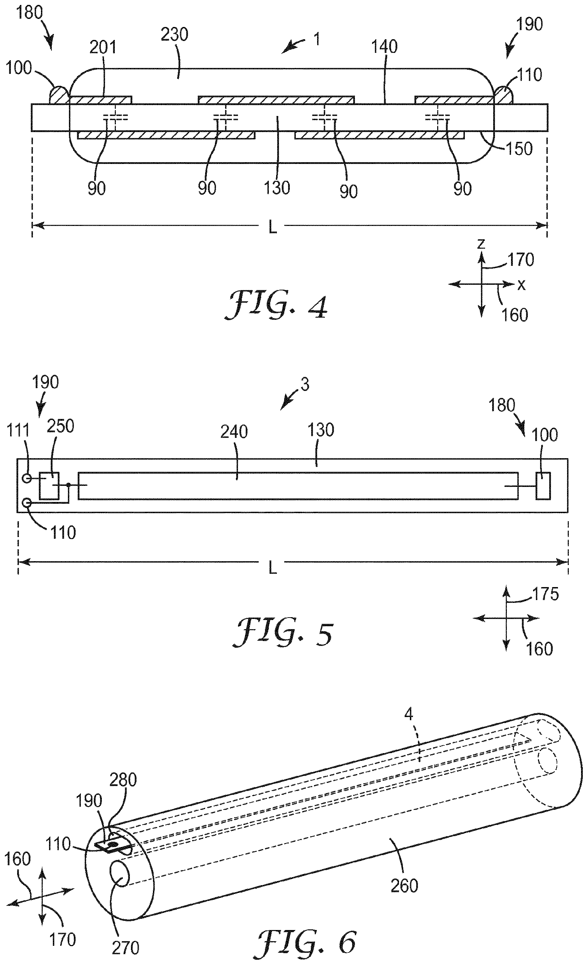

In order to further reduce the risk of electrical discharges between elements of an impedance assembly according to the present disclosure, an impedance assembly according to the present disclosure can be embedded in an electrically non-conductive encapsulating material. Such an embodiment is shown in Figure 4 in a longitudinal sectional view. It illustrates the first impedance assembly 1 of Figure 2 embedded in a body 230 of encapsulating material.

The encapsulating material is an electrically insulating hardened casting resin. When the casting resin was liquid, it was applied around the impedance assembly 1 in a suitably shaped mold and then let harden to become a solid body 230. The mold is shaped such that the body 230 leaves the first end portion 180 and the second end portion 190 free, and such that the outer shape of the body 230 corresponds to the shape of a cavity in an elastic sleeve, in which the impedance assembly 1 with its encapsulating body 230 is to be accommodated.

The dielectric strength of the encapsulating body 230 is higher than that of air, so that the likelihood of electric discharges between elements within the encapsulating body is less than it would be in air.

In order to keep the high-voltage-contact 100 and the low-voltage contact 110 accessible, e.g. for connection of wires, only about 85% of the length L of the impedance assembly 1 are embedded in the encapsulating material. The end portions 180, 190 of the impedance assembly 1 remain free of encapsulating material.

A further embodiment of an impedance assembly according to the present disclosure is illustrated in top view in **Figure 5****.** This third impedance assembly 3 can be used as part of a resistive voltage divider for sensing the high voltage of an inner conductor of a power cable 20 such as the one shown in Figure 1. The third impedance assembly 3 has an elongate shape and extends in length directions between a first end portion 180 and an opposed second end portion 190. Length (x) directions of the impedance assembly 3 are indicated by arrow 160, and its width (y) directions are indicated by arrow 175. Thickness directions are orthogonal to length directions 160 and width directions 175. The third impedance assembly 3 is a resistor assembly. It is designed for accommodation in a longitudinal cavity of an elastic sleeve for insulating a power cable.

The third impedance assembly 3 comprises a resistor layer 240, arranged on an outer surface of a substrate 130, namely a PCB 130, and extending between the first end portion 180 and the second end portion 190. A high-voltage contact 100, formed as s soldering point 100, is arranged on the first end portion 180, and it is designed to be galvanically connected to the inner conductor 10. The third impedance assembly 3 comprises two low-voltage contacts on the second end portion 190: a first low-voltage contact 110 and a second low-voltage contact 111. Both low-voltage contacts 110, 111 are soldering points, designed for connection to a low voltage of about 10 Volt or less. Both low-voltage contacts 110, 111 are arranged at a distance of about 12 cm from the high-voltage contact 100. The entire impedance assembly 3 has a length L of about 14 cm.

The resistor layer 240 provides a resistance, over its length, of about 200 MΩ. It is electrically connected in series between the high-voltage contact 100 and the first low-voltage contact 110. The resistor layer 240 is made of a high-resistance coating, such as a nickel-chromium-iron alloy for example, on the PCB 130. It is operable as a high-voltage side of a voltage divider, such as the voltage divider 50 shown in Figure 1, between low voltage (or ground) and the high voltage of the inner conductor 10 of the cable 20. High voltage at the high-voltage contact 100 is divided down to about 10 Volt at the first low-voltage contact 110. The large surface of the resistor layer 240 dissipates heat effectively.

The third impedance assembly 3 comprises a further resistor, namely a low-voltage resistor 250, also formed as a surface resistor on the outer surface of the PCB 130. The low-voltage resistor 250 has a resistance of about 20 kΩ. It is connected in series between the high-voltage contact 100 and the second low-voltage contact 111. It is operable as the low-voltage side of a voltage divider between the high voltage and ground. The second low-voltage contact 111 is a soldering pad, adapted to be connected to electrical ground. The third impedance assembly 3 thus comprises an entire resistive voltage divider, namely the high-voltage side 60 and the low-voltage side 70. The first low-voltage contact 110 is the midpoint of this resistive voltage divider, and the output voltage, picked up from the first low-voltage contact 110, measured against electrical ground, is proportional to the high voltage of the inner conductor 10, the proportionality factor being the dividing ratio between the resistance of the low-voltage resistor 250 and the resistance of the resistor layer 240, hence 20 kΩ/200 MΩ = 1:10 000.

**Figure 6** illustrates, in a perspective view, how an impedance assembly according to the present disclosure can be accommodated in a cavity of an elastic sleeve. An elongate, tubular elastic sleeve 260 forms a longitudinal passageway 270, in which an inner conductor 10 of a cable 20 can be received. The sleeve 260 electrically insulates the cable 20. The sleeve 260 also forms a longitudinal cavity 280, extending in the length direction 160 of the sleeve 260, parallel to the length direction of the passageway 270. An impedance assembly 4, such as the impedance assemblies shown in Figures 2, 3, 4 and 5, is accommodated in the cavity 280. A second end portion 190 of the impedance assembly 4, protrudes from the cavity 280, so that the low-voltage contact 110 is accessible from outside the sleeve 260.

## Claims

1. Impedance assembly (1, 2, 4) for use in a voltage divider (50) for sensing an AC high voltage of between 6 kV and 175 kV of an inner conductor (10) of a power cable (20) distributing electrical energy in a national grid,
wherein the impedance assembly has an elongate shape defining a first end portion (180) and an opposed second end portion (190), for accommodation in a longitudinal cavity (280) of an elastic sleeve (260) for insulating the power cable, and wherein the impedance assembly comprises
a) a substrate (130, 131),
b) a high-voltage contact (100), arranged at the first end portion, for galvanic connection to the inner conductor,
c) a low-voltage contact (110, 111), arranged at the second end portion at a distance of at least 10 centimetres from the high-voltage contact, for electrical connection to a low voltage of 10 volt or lower, and
d) at least four dividing capacitors (90, 91), electrically connected in series between the high-voltage contact and the low-voltage contact such as to provide a combined capacitance of at least 10 picofarad, and operable as a high-voltage side (60) of the voltage divider between the low voltage and the high voltage of the inner conductor,
wherein each dividing capacitor has two electrodes formed by opposed conductive areas (201, 202, 203, 204, 205, 301, 302, 303, 304, 305, 306) on or in the substrate, and a dielectric comprising a portion of the substrate.

2. Impedance assembly according to claim 1, comprising a total of six dividing capacitors (90, 91), electrically connected in series between the high-voltage contact (100) and the low-voltage contact (110, 111) such as to provide a combined capacitance of at least 10 picofarad, and operable as a high-voltage side of the voltage divider between the low voltage and the high voltage of the inner conductor,
wherein each dividing capacitor has two electrodes formed by opposed conductive areas on or in the substrate, and a dielectric comprising a portion of the substrate (130, 131).

3. Impedance assembly according to any one of the preceding claims, wherein the at least four dividing capacitors (90, 91) are electrically connected in series between the high-voltage-contact (100) and the low-voltage contact (110, 111) such as to provide a combined capacitance of at least 50 picofarad.

4. Impedance assembly according to any one of the preceding claims, wherein the substrate (131) is a multilayer printed circuit board comprising two conductive areas (302, 303) in the printed circuit board forming electrodes of one of the at least four dividing capacitors (91).

5. Impedance assembly (3, 4) for use in a voltage divider (50) for sensing an AC high voltage of between 6 kV and 175 kV of an inner conductor (10) of a power cable (20) distributing electrical energy in a national grid,
wherein the impedance assembly has an elongate shape defining a first end portion (180) and an opposed second end portion (190), for accommodation in a longitudinal cavity (280) of an elastic sleeve (260) for insulating the power cable, and wherein the impedance assembly comprises
a) a substrate (130),
b) a high-voltage contact (100), arranged at the first end portion, for galvanic connection to the inner conductor,
c) a low-voltage contact (110, 111), arranged at the second end portion at a distance of at least 12 centimetres from the high-voltage contact, for electrical connection to a low voltage of 10 volt or lower, and
d) a resistor layer (240), arranged on an inner or an outer surface of the substrate and extending between the first end portion and the second end portion, electrically connected in series between the high-voltage contact and the low-voltage contact such as to provide a resistance of at least 50 MΩ, wherein the resistor layer is operable as a high-voltage side (60) of the voltage divider between the low voltage and the high voltage of the inner conductor.

6. Impedance assembly according to claim 5, wherein the resistor layer (240) extends lengthwise for at least 100 mm.

7. Impedance assembly (3) according to claim 5 or 6, further comprising a second resistor layer (250), electrically connected in series with the first resistor layer (240), operable as a low-voltage side (70) of the voltage divider (50) for sensing a voltage of the inner conductor (10).

8. Impedance assembly according to any one of the preceding claims, wherein the substrate (130, 131) is a ceramic body.

9. Impedance assembly according to any one of claims 1 to 7, wherein the substrate (130, 131) is a printed circuit board.

10. Impedance assembly according to claim 9, wherein the printed circuit board comprises a ceramic material.

11. Impedance assembly according to any one of the preceding claims, wherein at least 50% of the length of the impedance assembly is embedded in an electrically non-conductive encapsulating material (230).

12. Impedance assembly according to any one of the preceding claims, wherein the impedance assembly has a length of 50 centimetres or less.

13. Combination of
a) a cable termination or a cable plug, comprising an elastic sleeve (260) for electrically insulating a power cable (20), the sleeve having a longitudinal cavity (280) for accommodating an impedance assembly (1, 2, 3, 4) according to any one of claims 1 to 12, and
b) an impedance assembly (1, 2, 3, 4) according to any one of claims 1 to 12, arranged in the cavity of the sleeve.

14. Kit of parts, comprising
a) an elastic sleeve (260) for electrically insulating a power cable (20), the sleeve having a longitudinal cavity (280) for accommodating an impedance assembly (1, 2, 3, 4) according to any one of claims 1 to 12, and
b) an impedance assembly (1, 2, 3, 4) according to any one of claims 1 to 12.

15. Power network for distributing energy in a national grid, comprising a power cable (20) including an inner conductor (10), and a voltage divider (50), connected to the inner conductor, for sensing an AC high voltage of the inner conductor, the voltage divider comprising an impedance assembly (1, 2, 3, 4) according to any one of claims 1 to 12.
